Europäisches Patentamt

(19) ))) European Patent Office

Office européen des brevets

(11) Veröffentlichungsnummer: **0 104 478**
**B1**

(12) **EUROPÄISCHE PATENTSCHRIFT**

(45) Veröffentlichungstag der Patentschrift:
24.06.87

(21) Anmeldenummer: 83108549.3

(22) Anmeldetag: 30.08.83

(51) Int. Cl.⁴: **G 01 R 31/28**

(54) Anordnung und Verfahren zur Spannungsmessung an einem vergrabenen Messobjekt.

(30) Priorität: 02.09.82 DE 3232671

(43) Veröffentlichungstag der Anmeldung:
04.04.84 Patentblatt 84/14

(45) Bekanntmachung des Hinweises auf die Patenterteilung:
24.06.87 Patentblatt 87/26

(84) Benannte Vertragsstaaten:
DE FR GB NL

(56) Entgegenhaltungen:
DE - A - 2 824 308

(73) Patentinhaber: Siemens Aktiengesellschaft Berlin und München, Wittelsbacherplatz 2, D-8000 München 2 (DE)

(72) Erfinder: Froslen, Jürgen, Dr.-Ing., An der Ottosäule 18, D-8012 Ottobrunn (DE)
Erfinder: Pomper, Michael, Dipl.-Ing., Miesbacher Strasse 34, D-8012 Schliersee (DE)

## Beschreibung

Die Erfindung betrifft eine Anordnung für kapazitive Spannungsmessungen mit einer Korpuskularstrahlsonde an einem Messobjekt, das durch mindestens eine Festkörpersubstanz räumlich von einer Oberfläche getrennt ist, nach dem Oberbegriff des Patentanspruchs 1, und ein Verfahren zur Messung der Spannung nach dem Oberbegriff des Anspruchs 4.

Die Elektronenstrahl-Messtechnik hat sich in der Vergangenheit als praktikable Methode zur berührungslosen Messung von Spannungsverläufen in integrierten Schaltkreisen bewährt (H.P. Feuerbaum, «VLSI Testing Using the Electron Probe», Scanning Electron Microscopy/1979/I, 285–296). Das von H.P. Feuerbaum beschriebene Messprinzip ist dabei auf Messpunkte angewandt worden, die sich an der Schaltungsoberfläche befinden. Mit fortschreitendem Integrationsgrad der Schaltkreise werden aber immer häufiger Mehrlagen-Verdrahtungen angewendet, so dass künftig auch die Notwendigkeit besteht, das Potential von im Halbleiterchip vergrabenen Leiterbahnen zu bestimmen.

Nach dem Stand der Technik gibt es zur quantitativen Spannungsmessung an vergrabenen Leiterbahnen kein einfaches und leistungsfähiges Messverfahren, welches ohne zusätzliche Bearbeitungs- bzw. Prozessschritte am Schaltkreis auskommt. Von J. Frosien ist vorgeschlagen worden, die verborgenen Leiterbahnen anzubohren und das Potential dieser Leiterbahnen durch die Bohrungen hindurch zu bestimmen. Ein solches Verfahren benötigt jedoch einen beträchtlichen zusätzlichen Bearbeitungsaufwand.

Ein Verfahren und eine Anordnung zur Spannungsmessung nach den Oberbegriffen der Patentansprüche 1 und 4 an passivierten Leiterbahnen ist aus der Veröffentlichung von L. Kotorman «Non-Charging Electron Beam Pulse Prober on FET Wafers» Scanning Electron Microscopy/1980/IV Seiten 77 ff., insbesondere Seite 82 Fig. 11, bekannt. Es wird vorgeschlagen, die Leiterbahnpotentiale mittelbar über die durch Polarisation des Isolators erzeugten und mit Hilfe einer Elektronensonde detektierten Oberflächenladungen zu bestimmen. Ein solches Verfahren dürfte in der Praxis allerdings nur ungenaue Messergebnisse liefern, da die polarisierte Oberfläche des Isolators eine äusserst belastungsarme Spannungsquelle darstellt, die allein durch die Kapazität der von der Korpuskularstrahl-Sonde bestrahlten Oberfläche des Isolators bestimmt wird. Ausserdem entspricht die durch ein inhomogenes elektrisches Feld an der Oberfläche des Isolators erzeugte Spannungsverteilung nicht der Spannungsverteilung an der Leiterbahn.

Aus der deutschen Offenlegungsschrift 2 824 308 ist ein Verfahren und eine Anordnung zum Einprägen einer Spannung in ein elektronisches Bauelement bekannt. Zur Überprüfung der Funktion integrierter Schaltungen wird deren Passivierungsschicht teilweise mit einem Metallfilm überzogen, den man anschliessend in geeigneter Weise kontaktiert und mit einer Spannungsquelle leitend verbindet. Das Durchschalten der von dieser Quelle gelieferten Spannung erfolgt mit Hilfe eines auf der Metallschicht positionierten Elektronenstrahles, der innerhalb der Passivierungsschicht eine lokale Leitfähigkeit induziert und damit die auf dem gewünschten Potential liegende Metallschicht und den interessierenden Schaltungsteil kurzschliesst.

Der vorliegenden Erfindung liegt die Aufgabe zugrunde, eine Anordnung und ein Verfahren der eingangs genannten Art anzugeben, welche bei der Spannungsmessung an vergrabenen Messobjekten gute Messergebnisse ermöglichen.

Diese Aufgabe wird erfindungsgemäss durch eine Anordnung und durch ein Verfahren der eingangs genannten Art gelöst, welche die kennzeichnenden Merkmale des Anspruchs 1 bzw. des Anspruchs 4 aufweisen. Ausgestaltungen und Vorteile der Erfindung sind in den jeweiligen Unteransprüchen, in der Beschreibung und in der Zeichnung dargestellt.

Ausführungsbeispiele der Erfindung sind in der Zeichnung dargestellt und werden im folgenden näher beschrieben.

Fig. 1 zeigt das Prinzip einer kapazitiven Spannungsmessung mit einer Korpuskularstrahl-Sonde an der Oberfläche eines Isolators nach dem Stand der Technik.

Fig. 2 zeigt das Prinzip einer kapazitiven Spannungsmessung mit einer Korpuskularstrahl-Sonde über einen gemäss der Erfindung isoliert angebrachten Messfleck.

Fig. 3 zeigt eine Sandwich-Anordnung metallischer Messflecken zur kapazitiven Überkoppelung tief vergrabener Potentiale gemäss der Erfindung.

Fig. 4 zeigt das Prinzip der Spannungsmessung über eine Phasenmodulation der Korpuskularstrahl-Sonde, wobei die Spannung am Messobjekt zwischen dem zu vermessenden Potential und einer Referenzspannung hin- und hergeschaltet wird.

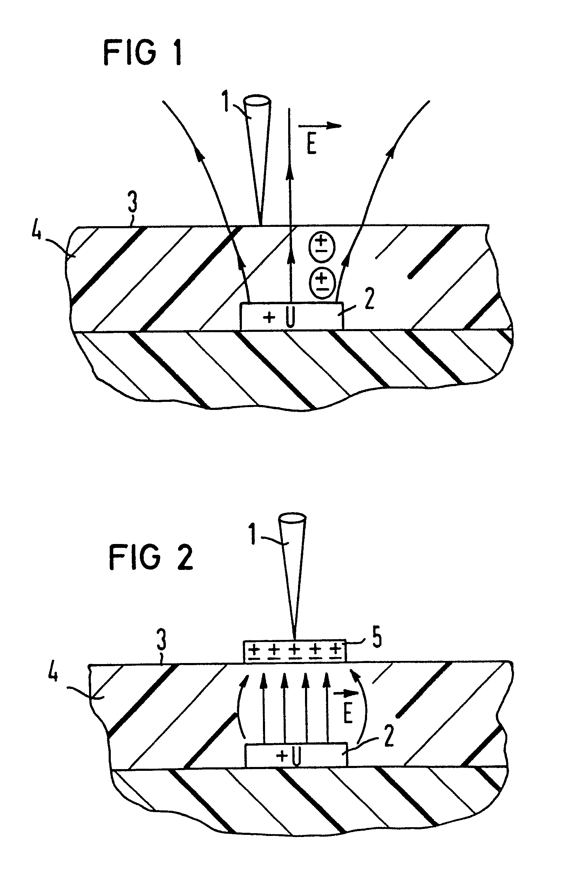

Fig. 1 zeigt das Prinzip der kapazitiven Spannungsmessung an der Oberfläche 3 eines Isolators 4 mit Hilfe einer Korpuskularstrahl-Sonde 1 nach Kotorman. An dem Messobjekt 2, einer vergrabenen Leiterbahn, welches von der Oberfläche 3 durch andere Festkörpersubstanz 4 räumlich getrennt ist, liegt die Spannung $+U$ an. Infolge dieser Spannung $+U$ an dem Messobjekt 2 werden die elektrischen Dipole des Isolators 4 polarisiert. Die Korpuskularstrahl-Sonde 1 wird auf einen Teil der Oberfläche 3 oberhalb des Messobjekts 2 gerichtet. Dieses bekannte Messverfahren dürfte in der Praxis nur ungenaue Messergebnisse liefern, da erstens die polarisierte Oberfläche 3 eine äusserst belastungsarme Spannungsquelle darstellt, die allein durch die Kapazität der von der Korpuskularstrahl-Sonde 1 bestrahlten Teilfläche der Oberfläche 3 bestimmt wird, und da zweitens die Spannungsverteilung an der Oberfläche 3 nicht der Spannungsverteilung des vergrabenen Messobjekts 2 entspricht, da diese Spannungsverteilung an der Oberfläche 3 durch ein inhomogenes elektrisches Feld $\vec{E}$ erzeugt wird.

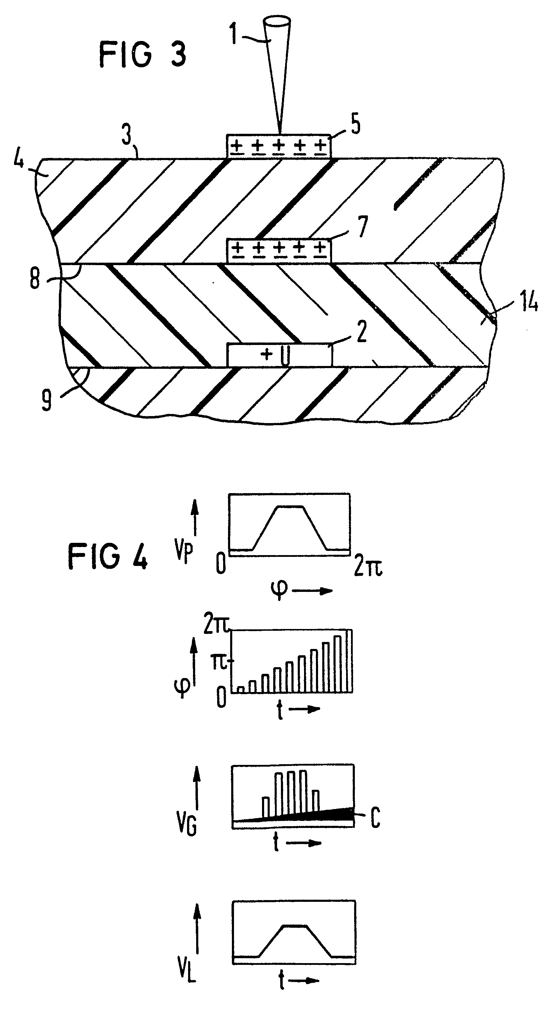

Fig. 2 zeigt das Prinzip einer kapazitiven Spannungsmessung über einem isoliert angebrachten Messfleck 5 gemäss der Erfindung. Zwischen dem Messobjekt 2 und der Korpuskularstrahl-Sonde 1 ist mindestens eine Festkörpersubstanz 5 angeordnet, welche bewegliche Ladungen aufweist. Oberhalb des vergrabenen Messobjekts 2, im Beispiel wiederum eine vergrabene Leiterbahn, ist auf dem Isolator 4 ein metallischer Messfleck 5 angebracht. An dem vergrabenen Messobjekt 2 liegt wiederum die Spannung +U an. Durch Influenz tritt auf dem isoliert auf der Oberfläche 3 angebrachten Messfleck 5 eine Ladungstrennung ein, so dass sich auf der Oberfläche des Messflecks 5 ein Potential einstellt, das dem Potential +U auf der vergrabenen Leiterbahn 2 proportional ist. Sind die Kantenlängen der sich gegenüberstehenden Flächen von vergrabener Leiterbahn 2 und Messfleck 5 gross im Vergleich zur Dicke des dazwischenliegenden Isolators 4, so liegen Verhältnisse vor, die denen in einem Plattenkondensator ähneln. Die Spannungsverteilung an der der Korpuskularstrahl-Sonde 1 zugewandten Oberfläche des Messflecks 5 entspricht in etwa der Spannungsverteilung an der Leiterbahn 2, da diese Spannungsverteilung an der der Korpuskularstrahl-Sonde 1 zugewandten Oberfläche des Messflecks 5 durch ein in etwa homogenes elektrisches Feld $\vec{E}$ erzeugt wird. Das Potential an der der Korpuskularstrahl-Sonde 1 zugewandten Oberfläche des Messflecks 5 entspricht dann dem Potential +U an der vergrabenen Leiterbahn 2. Das Potential an der der Korpuskularstrahl-Sonde 1 zugewandten Oberfläche des Messflecks 5 kann nun mit den bekannten Methoden der Elektronenstrahl-Messtechnik bestimmt werden. Da der Messfleck 5 während der Potentialmessung durch den abtastenden Primärkorpuskularstrahl 1 aufge- bzw. entladen werden kann, kann sich dem zu messenden Potential die Ladekurve des aus Messobjekt 2 und Messfleck 5 bestehenden Kondensators überlagern. Um diesen Nebeneffekt so klein wie möglich zu halten, muss erstens die Kapazität der aus Messobjekt 2 und Messfleck 5 bestehenden Anordnung genügend gross sein, so dass die sich während der Messung aufbauende zusätzliche Störspannung hinreichend klein bleibt, was durch eine entsprechende Grösse des Messflecks 5 erreicht werden kann, und/oder zweitens muss die Energie des Primärkorpuskularstrahls 1 so gewählt werden, dass die Summe aus Rückstreukorpuskeln und Sekundärkorpuskeln gleich der Summe der auf die Oberfläche des Messflecks 5 auftreffenden Primärelektronen ist. Der Messfleck 5 lädt sich dann nicht auf, die Messung erfolgt also belastungsfrei.

Lassen sich diese zuletzt genannten beiden Bedingungen zur Minimierung der sich während der Messung aufbauenden zusätzlichen Störspannung nicht ausreichend erfüllen, so muss zusätzlich die Methode der Phasenmodulation der Korpuskularstrahl-Sonde 1 angewandt werden, wie sie aus Seite 292 der genannten Veröffentlichung von H.P. Feuerbaum bekannt ist und wie sie anhand der Fig. 4 weiter unten näher beschrieben wird.

Fig. 3 zeigt eine Sandwich-Anordnung metallischer Messflecken 5, 7 zur kapazitiven Überkoppelung tief vergrabener Potentiale. Das an dem vergrabenen Messobjekt 2, im Beispiel wiederum einer vergrabenen Leiterbahn, angelegte Potential +U ruft durch Influenz auf dem isoliert angebrachten Messfleck 7 eine Ladungstrennung hervor, welche ihrerseits wiederum auf dem isoliert angebrachten Messfleck 5 eine Ladungstrennung bewirkt. Der metallische Zusatzfleck 7 zur kapazitiven Koppelung ist in der Zwischenebene 8 zwischen den Isolatoren 4 und 14 angeordnet. Soll das Potential +U auf sehr tief gelegenen Messobjekten 2 bestimmt werden, z.B. auf der dritten Metallisierungsebene 9 oder auch noch tiefer gelegenen Metallisierungsebenen, so lassen sich durch in den Zwischenebenen 8 angebrachte weitere metallische Zusatzflecken die kapazitive Kopplung zwischen dem Messobjekt 2 und dem metallischen Messfleck 5 erhöhen und die Messung erleichtern.

Anhand von Fig. 4 wird eine Methode aus der genannten Veröffentlichung von H.P. Feuerbaum erläutert, mit deren Hilfe eine sich während der Messung an der der Korpuskularstrahl-Sonde 1 zugewandten Oberfläche des Messflecks 5 aufbauende zusätzliche Spannung aus dem Messergebnis eliminiert werden kann. Bei dieser sogenannten Methode des Phasenspringens bzw. der Phasenmodulation wird die Spannung am Messobjekt 2 zwischen dem zu vermessenden Potential und einer Referenzspannung hin- und hergeschaltet. Die Referenzspannung mag dabei beispielsweise 0 Volt betragen. In Fig. 4 ist beispielsweise eine Periode einer zu messenden Spannung $V_P$ dargestellt. Beim Abtasten der Wellenform dieser Spannung $V_P$ wird die Phase $\varphi$ der Korpuskularstrahl-Sonde 1 nicht wie üblich kontinuierlich verändert, sondern sprungweise. Dabei trifft die Korpuskularstrahl-Sonde 1 auf die Oberfläche des Messflecks 5 alternierend einmal mit einer sprungsweise zugenommenen Phase $\varphi$ und dann wieder mit einer Referenzphase, die in Fig. 4 mit $\varphi = 0$ gezeigt ist, auf. Das System zur Verarbeitung der Sekundärkorpuskel-Signale misst die Spannung $V_G$ während der sprungweisen zugenommenen Phase und während der Referenzphase, und liefert sodann die Differenz dieser Spannungen $V_G$ als das Messergebnis. Die Spannung $V_G$ enthält nämlich aufgrund der Phasenmodulation der Korpuskularstrahl-Sonde 1 eine Wechselspannungskomponente. Diese Wechselspannungskomponente kann mit Hilfe eines lock-in-Verstärkers detektiert und über mehrere Phasen der Korpuskularstrahl-Sonde hinweg integriert werden. Als Ergebnis dieser Prozedur erhält man die Spannung $V_L$, welche unbeeinflusst von Störungen ist und der zu messenden Spannung $V_P$ gleich ist.

Die Methode der Phasenmodulation kann auch dann angewendet werden, wenn an dem Messobjekt 2 lediglich eine Gleichspannung zu messen ist. Dann kann beispielsweise die zu vermessende Leiterbahn während der Messung alternierend zwischen der zu vermessenden Gleichspannung und 0 Volt hin- und hergeschaltet werden. Dadurch kann ebenso wie bei der Methode nach Fig. 4 die infolge von Kontamination auftretende zusätzliche Spannung C ermittelt und von der Messkurve abgezogen werden.

Der der Kospuskularstrahl-Sonde 1 nächstbenachbarte Messfleck 5 kann auch unter der Oberfläche 3 vergraben sein. Dann kann über Teilchen-Loch-Anregungen eine leitende Verbindung zwischen der Oberfläche des der Korpuskularstrahl-Sonde 1 nächstbenachbarten Messflecks 5 und der Auftrefffläche der Korpuskularstrahl-Sonde 1 auf die Oberfläche 3 geschaffen werden.

## Patentansprüche

1. Anordnung für kapazitive Spannungsmessungen mit einer Korpuskularstrahl-Sonde (1) an einem Messobjekt (2), das durch mindestens eine Festkörpersubstanz (4, 14) räumlich von einer Oberfläche (3) getrennt ist, dadurch gekennzeichnet, dass mindestens eine weitere, bewegliche Ladungen aufweisende Festkörpersubstanz (5, 7) zwischen dem Messobjekt (2) und der Korpuskularstrahl-Sonde (1) isoliert angeordnet ist, dass mindestens eine der bewegliche Ladungen aufweisenden Festkörpersubstanzen (5, 7) als metallischer Messfleck (5) ausgebildet und am Auftreffpunkt der Korpuskularstrahl-Sonde (1) in Strahlrichtung oberhalb des Messobjektes (2) an der Oberfläche (3) angeordnet ist, so dass in dem Messfleck (5) eine Ladungstrennung durch Influenz auftritt und sich an dessen Oberfläche ein dem Potential des Messobjektes (5) proportionales Potential aufbaut.

2. Anordnung nach Anspruch 1, dadurch gekennzeichnet, dass in Strahlrichtung zwischen dem an der Oberfläche (3) und oberhalb des Messobjekts (2) angeordneten metallischen Messfleck (5) und dem Messobjekt (2) mehrere, jeweils durch eine Festkörpersubstanz (4, 14) räumlich voneinander getrennte metallische Messflecken (7) isoliert angeordnet sind.

3. Anordnung nach Anspruch 1 oder 2, dadurch gekennzeichnet, dass der isoliert an der Oberfläche (3) angeordnete metallische Messfleck (5) hinreichend gross ist zur Vermeidung einer sich während der Messung aufbauenden störenden zusätzlichen Spannung (C).

4. Verfahren zur Messung der Spannung an einem Messobjekt (2), das durch mindestens eine Festkörpersubstanz (4, 14) räumlich von einer Oberfläche (3) getrennt ist, bei dem eine Korpuskularstrahl-Sonde (1) auf die Oberfläche (3) oberhalb des Messobjektes (2) gerichtet wird, dadurch gekennzeichnet, dass mindestens eine weitere, bewegliche Ladungen aufweisende Festkörpersubstanz (5, 7) zwischen dem Messobjekt (2) und der Korpuskularstrahl-Sonde (1) isoliert angeordnet wird, dass mindestens eine dieser Festkörpersubstanzen (5) in Form eines metallischen Messfleckes (5) ausgebildet und in Strahlrichtung oberhalb des Messobjektes (2) an der Oberfläche (3) isoliert angeordnet wird, dass die Korpuskularstrahl-Sonde (1) auf diesem Messfleck (5) positioniert wird, dass eine Spannung (+U) an das Messobjekt (2) angelegt wird, so dass in mindestens einer der Festkörpersubstanzen (5, 7) eine Ladungstrennung durch Influenz hervorgerufen wird, und dass das durch kapazitive Kopplung an der Oberfläche des Messfleckes (5) erzeugte und dem Potential des Messobjektes (2) proportionale Potential mit der Korpuskularstrahl-Sonde (1) durch Nachweis der am Messfleck (5) ausgelösten Sekundärkorpuskeln bestimmt wird.

5. Verfahren nach Anspruch 4, dadurch gekennzeichnet, dass die Summe der auf die Oberfläche (3) auftreffenden Ladungen etwa gleich der Summe der die Oberfläche (3) verlassenden Ladungen ist.

6. Verfahren nach Anspruch 4 oder 5, dadurch gekennzeichnet, dass die Spannung am Messobjekt (2) zwischen dem zu vermessenden Potential und einer Referenzspannung hin- und hergeschaltet wird, wodurch Störeinflüsse aus dem Messergebnis eliminiert werden können.

## Claims

1. An arrangement for capacitive voltage measurements by use of a corpuscular beam probe (1) on a test object (2) spatially separated from a surface (3) by at least one solid-state substance (4, 14), characterised in that at least one further solid-state substance (5, 7) having mobile charge-carriers is arranged between the test object (2) and the corpuscular radiation probe (1) so as to be insulated, that at least one of the solid-state substances (5, 7), which has mobile charge-carriers is a metallic test spot (5) and is arranged at the point of impact of the corpuscular beam probe (1) on the surface (3) in the direction of the beam path above the test object (2) so that charge separation is induced at the test spot (5) and a potential proportional to the potential of the test object (5) is built up on the surface of said test spot.

2. An arrangement as claimed in Claim 1, characterised in that a plurality of metallic test spots (7) are arranged in the direction of the radiation beam path between the metallic test spot (5) on the surface (3) and the test object (2), spatially separated from one another by a solid-state substance (4, 14), so as to be insulated.

3. An arrangement as claimed in Claim 1 or 2, characterised in that the metallic test spot (5) arranged on the surface (3) in insulated fashion is sufficiently large to avoid a disturbing additional voltage (C) being built up during the measurement.

4. A method of measurement of the voltage on a test object (2) which is spatially separated from a surface (3) by at least one solid-state substance (4, 14), wherein a corpuscular beam probe (1) is directed to the surface (3) above the test object (2) characterised in that at least one further solid-state substance (5, 7), which has mobile charge-carriers, is arranged in insulated fashion between the test object (2) and the corpuscular beam probe (1), that at least one of said solid-stage substances (5) is a metallic test spot (5) and arranged in the beam path direction above the test object (2) on the surface (3) so as to be insulated, that the corpuscular beam probe (1) is positioned on the test spot (5), that a voltage (+U) is connected to the test object (2), so that in at least one of the solid-state substances (5, 7) a charge separation is induced, and that the potential produced by capacitive coupling on the surface of the test spot (5) and proportional to the potential of the test object (2) is determined using the corpuscular beam probe (1), by detecting secondary corpuscles triggered at the test spot (5).

5. A method as claimed in Claim 4, characterised in that the sum of the charges hitting the surface (3) approximately corresponds to the sum charge leaving the surface (3).

6. A method as claimed in Claim 4 or 5, characterised in that the voltage on the test object (2) is switched to and fro between the potential to be measured and a reference voltage, whereby interference can be eliminated from the test result.

**Revendications**

1. Dispositif pour effectuer des mesures capacitives à l'aide d'une sonde à faisceau corpusculaire (1) sur un objet de mesure (2), qui est séparé dans l'espace par rapport à une surface (3), par au moins une substance formée d'un corps solide (4, 14), caractérisé par le fait qu'au moins une autre substance formée d'un corps solide (5, 7), comportant des charges mobiles, est disposée avec isolation entre l'objet de mesure (2) et la sonde à faisceau corpusculaire (1), qu'au moins l'une des substances formées d'un corps solide (5, 7), comportant des charges mobiles, est réalisée sous la forme d'un plot métallique de mesure (5) et est disposée au niveau du point d'impact de la sonde à faisceau corpusculaire (1), sur la surface (3), au-dessus de l'objet de mesure (2) suivant la direction du rayonnement, de telle sorte qu'une séparation des charges par influence se produit dans le plot de mesure (5) et qu'un potentiel proportionnel au potentiel de l'objet de mesure (5) s'établit au niveau de la surface du plot de mesure.

2. Dispositif suivant la revendication 1, caractérisé par le fait que plusieurs plots métalliques de mesure (7) séparés les uns des autres dans l'espace par des substances respectives formées de corps solides (4, 14) sont disposés, en étant isolés, sur le trajet de rayonnement, entre le plot métallique de mesure (5) disposé sur la surface (3) et au-dessus de l'objet de mesure (3), et l'objet de mesure (2).

3. Dispositif suivant la revendication 1 ou 2, caractérisé par le fait que le plot métallique de mesure (5) disposé en étant isolé sur la surface (3) est suffisamment étendu pour éviter une tension perturbatrice supplémentaire (C) s'établissant pendant la mesure.

4. Procédé pour mesurer la tension sur un objet de mesure (2) qui est séparé dans l'espace par rapport à une surface (3) par au moins une substance formée d'un corps solide (7, 14), et selon lequel on dirige une sonde à faisceau corpusculaire (1) sur la surface (3), au-dessus de l'objet de mesure (2), caractérisé par le fait qu'on dispose à l'état isolé au moins une autre substance formée d'un corps solide (5, 7), comportant les charges mobiles, entre l'objet de mesure (2) et la sonde à faisceau corpusculaire (1), qu'on réalise au moins l'une de ces substances formées de corps solides (5) sous la forme d'un plot métallique de mesure (5) et qu'on le dispose, à l'état isolé, sur la surface (3), au-dessus de l'objet de mesure (2) dans le trajet du rayonnement, et qu'on positionne la sonde à faisceau corpusculaire (1) sur ce plot de mesure (5), qu'on applique une tension (+U) à l'objet de mesure (2) de telle sorte qu'une séparation des charges par influence est prévoquée dans au moins l'une des substances formées d'un corps solide (5, 7) et qu'on détermine le potentiel, produit par le couplage capacitif à la surface du plot de mesure (5) et proportionnel au potentiel de l'objet de mesure (2), au moyen de la sonde à faisceau corpulaire (1) par détection des corpuscules secondaires, dont l'émission est déclenchée sur le plot de mesure (5).

5. Procédé suivant la revendication 4, caractérisé par le fait que la somme des charges tombant sur la surface (3) est égale approximativement à la somme des charges quittant la surface (3).

6. Procédé suivant la revendication 4 ou 5, caractérisé par le fait qu'on réalise une commutation en va-et-vient de la tension appliquée à l'objet de mesure (2) entre le potentiel à mesurer et une tension de référence, ce qui permet d'éliminer des influences parasites du résultat de la mesure.

## FIG 1

## FIG 2

# FIG 3

# FIG 4